# EUROPEAN PATENT SPECIFICATION

(11) **EP 4 084 498 B1**
(45) Date of publication and mention of the grant of the patent: **08.10.2025**
(21) Application number: 20907169.5
(22) Date of filing: 01.04.2020
(51) Int. Cl.: H04R 19/00, H04R 3/00

(54) **MEMS CHIP**
MEMS-CHIP
PUCE MEMS

(30) Priority: 27.12.2019 CN 201922402214 U
(43) Date of publication of application: 02.11.2022
(73) Proprietor: Weifang Goertek Microelectronics Co., Ltd., Weifang, Shandong 261031 (CN)
(72) Inventor: QIU, Guanxun, Weifang, Shandong 261031 (CN); WU, Ansheng, Weifang, Shandong 261031 (CN); LIU, Bo, Weifang, Shandong 261031 (CN)
(74) Representative: Rau, Schneck & Hübner Patentanwälte Rechtsanwälte PartGmbB
(86) International application number: PCT/CN2020/082659
(87) International publication number: WO 2021/128638

(56) References cited:
- EP-A1- 3 518 558
- CN-A- 102 792 715
- CN-A- 103 563 399
- CN-A- 103 702 268
- CN-U- 203 368 748
- US-A1- 2011 073 967
- US-A1- 2015 001 647
- US-A1- 2017 125 173
- US-A1- 2018 234 774

## Description

### TECHNICAL FIELD

The present disclosure relates to the technical field of electroacoustic products, and particularly to a MEMS chip.

### BACKGROUND

A traditional MEMS chip includes a substrate, as well as a diaphragm and a back electrode fixed to the substrate. The diaphragm and the back electrode have a certain gap therebetween. The diaphragm and the back electrode constitute a capacitor and are integrated on a silicon wafer. Vibration of the diaphragm changes a distance between the diaphragm and the back electrode, thereby converting a sound signal into an electrical signal.

With the development of the times and the progress of science and technology, various consumer electronics products are being upgraded in an increasingly fast pace. For a MEMS chip, its application environment is becoming more and more complex, which requires lower distortion of the MEMS chip. At present, the MEMS chip with a single back-electrode structure in the prior art has low linearity and large harmonic distortion; and when an inductive diaphragm vibrates, or during a drop test, the problem of adhesion between the diaphragm and the back electrode often occurs, thereby influencing the performance of the MEMS chip.

Therefore, in order to overcome the defects of the prior art, it is necessary to provide a new MEMS chip.

MEMS microphones are disclosed in EP 3 518 558 A1, US 2015/0001647 A1 and US 2018/0234774 A1. US 2017/0125173 A1 discloses a super capacitor with moveable separator and a method of operating a super capacitor.

### SUMMARY

An object of the present disclosure is to provide a MEMS chip, which can effectively mitigate the linear distortion, improve the ability to suppress the linear distortion, and enhance the performance of the MEMS chip.

In order to solve the above technical problem, a MEMS chip according to claim 1 is provided.

In addition, in a preferred solution, the first diaphragm and/or the second diaphragm includes an air leakage structure.

In addition, in a preferred solution, a hermetic space is formed between the first diaphragm and the second diaphragm.

In addition, in a preferred solution, a first restraining portion for restraining deformation of the first diaphragm toward the first back electrode is provided between the first back electrode and the first diaphragm; a second restraining portion for restraining deformation of the second diaphragm toward the second back electrode is provided between the second back electrode and the second diaphragm.

According to the invention, the first back electrode is located at a side of the first diaphragm away from the second plate capacitor structure, and the second diaphragm is located at a side of the second back electrode away from the first plate capacitor structure.

In addition, in a preferred solution, a spacing between the first diaphragm and the second back electrode is greater than a spacing between the first diaphragm and the first back electrode, and greater than a spacing between the second diaphragm and the second back electrode, respectively.

The beneficial effects of the present disclosure are as follows.
1. The first plate capacitor structure and the second plate capacitor structure provided by the MEMS chip of the present disclosure can form a differential capacitance to mitigate the linear distortion, improve the ability to suppress the linear distortion, and enhance the performance of the MEMS chip. In addition, the MEMS chip can realize an equipotential connection between the adjacent diaphragm and the substrate, avoid the mutual interference between the adjacent diaphragm and the substrate due to the potential difference, and avoid the accumulation of dust between the substrate and the adjacent diaphragm, thereby improving the performance and reliability of the MEMS chip.
2. With the first restraining portion between the first back electrode and the first diaphragm, the MEMS chip provided by the present disclosure can prevent the problem of adhesion or short circuit between the first diaphragm and the first back electrode; and with the second restraining portion located between the second back electrode and the second diaphragm, it is possible to prevent the problem of adhesion or short circuit between the second diaphragm and the second back electrode.
3. The first diaphragm and/or the second diaphragm of the MEMS chip provided by the present disclosure is provided with an air leakage structure, can excellently buffer the high-pressure airflow received by the first diaphragm and/or the second diaphragm, and at the same time reduce the acoustic impedance of the first diaphragm and/or the second diaphragm, thereby improving the acoustic properties of the MEMS chip such as sensitivity and SNR. In addition, the MEMS chip provided with the air leakage structure can be applied to more sensors, therefore expanding the application range of the MEMS chip provided by the present disclosure.

### BRIEF DESCRIPTION OF THE DRAWINGS

The specific embodiments of the present invention will be described in further detail below in conjunction with the accompanying drawings.

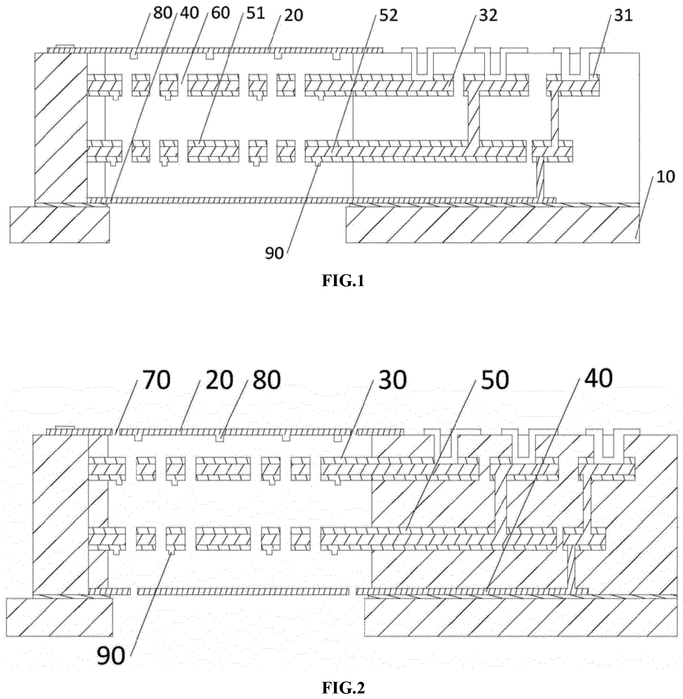

FIG. 1 shows a schematic structural diagram of a MEMS chip known from the prior art.
FIG. 2 shows a schematic structural diagram of a MEMS chip known from the prior art.
FIG. 3 shows a schematic structural diagram of a MEMS chip provided by the present disclosure.
FIG. 4 shows a schematic structural diagram of a MEMS chip provided by the present disclosure.

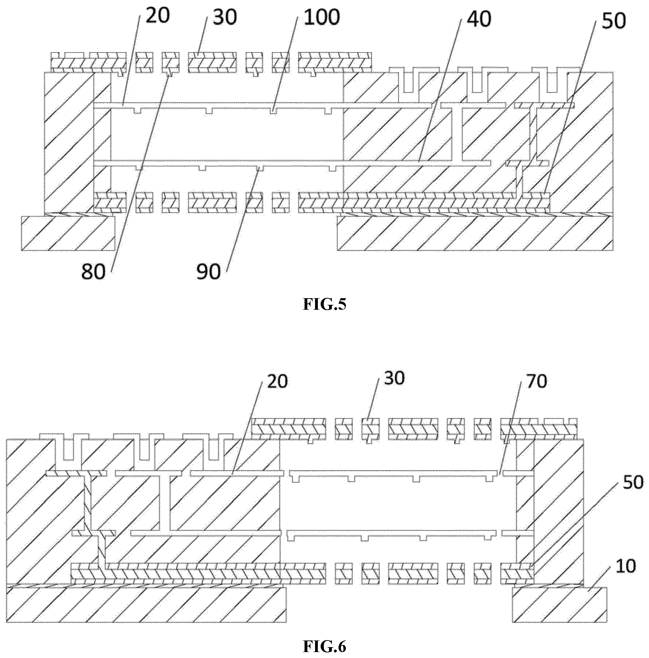

FIG. 5 shows a schematic structural diagram of a MEMS chip known from the prior art.
FIG. 6 shows a schematic structural diagram of a MEMS chip known from the prior art.

### DETAILED DESCRIPTION

In the following description, for the purposes of explanation, numerous specific details are set forth in order to provide a thorough understanding of one or more embodiments. It will be apparent, however, that the embodiments may be practiced without these specific details.

In order to illustrate the present disclosure more clearly, the present disclosure will be further described below with reference to the preferred embodiments and accompanying drawings. Similar parts in the figures are denoted by the same reference numerals. Those skilled in the art should understand that the content specifically described below is illustrative rather than restrictive, and should not limit the protection scope of the present disclosure.

At present, the MEMS chip with a single back-electrode structure in the prior art has low linearity and large harmonic distortion. In addition, adhesion between the diaphragm and the back electrode often occurs during vibration of an inductive diaphragm or during a drop test, thereby influencing the performance of the MEMS chip.

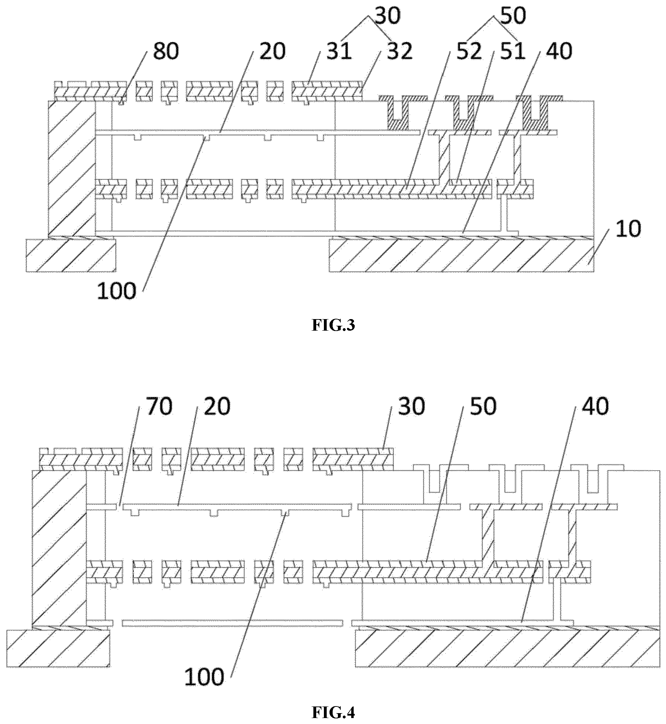

To solve the above technical problem, the present disclosure provides a MEMS chip. As shown in FIGS. 3 and 4, the MEMS chip includes: a substrate 10 with a back cavity, and a plate capacitor bank provided on the substrate 10; the plate capacitor bank at least includes a first plate capacitor structure and a second plate capacitor structure located below the first plate capacitor structure and arranged in parallel with the first plate capacitor structure. It is understood that the plate capacitor bank may also include three, four or more plate capacitor structures. In the following, a MEMS chip including two plate capacitor structures will be described in detail with reference to the accompanying drawings. The first plate capacitor structure includes a first diaphragm 20 and a first back electrode 30; and the second plate capacitor structure includes a second diaphragm 40 and a second back electrode 50. As shown in FIGS. 3 and 4, the first back electrode 30 is also provided with a plurality of through holes 60, so that air flow from the outside can enter via the through holes 60 and act on the first diaphragm 20 or the second diaphragm 40. Of course, a plurality of through holes may also be provided on the second back electrode, which belongs to the common knowledge of those skilled in the art and will not be described in detail here.

The MEMS chip provided by the present disclosure is provided with a first plate capacitor and a second plate capacitor, and the first plate capacitor and the second plate capacitor can form a differential capacitance, so as to mitigate linear distortion, improve the ability to suppress linear distortion, and enhance the performance of the MEMS chip. In addition, compared with the single-back electrode structure or the single-back-electrode double-diaphragm structure or the single-diaphragm double-back-electrode structure in the prior art, it is easy to accumulate dust in a space between the substrate and the adjacent diaphragm in the structure of the prior art. Further, in the prior art, it is common that the back electrode is connected to a high potential voltage, and the diaphragm is connected to a low potential voltage and a signal output, and when dust accumulates between the substrate and the adjacent diaphragm, there is a potential difference between the substrate (connected to the high potential voltage) and the adjacent diaphragm, resulting in mutual interference between the substrate and the adjacent diaphragm. The MEMS chip provided by the present disclosure can realize an equipotential connection between the adjacent diaphragm and the substrate, avoid the mutual interference between the adjacent diaphragm and the substrate due to the potential difference, and avoid the accumulation of dust between the substrate and the adjacent diaphragm, thereby improving the performance and reliability of the MEMS chip.

In a preferred embodiment, the first diaphragm 20 and/or the second diaphragm 40 includes an air leakage structure 70. That is, only the first diaphragm 20 is provided with the air leakage structure 70, or only the second diaphragm 40 is provided with the air leakage structure 70, or both the first diaphragm 20 and the second diaphragm 40 are provided with the air leakage structure 70. Specifically, the air leakage structure may be a pressure relief hole, a pressure relief valve, etc., wherein the pressure relief valve may be formed by a slot restriction, the pressure relief hole structure and the pressure relief valve structure may be formed by etching when the first diaphragm and/or the second diaphragm are formed by deposition. Such deposition and etching belong to the common knowledge of those skilled in the art, and will not be described in detail here; the pressure relief structure of the present disclosure may be in a structure well known to those skilled in the art, such as U-shape, S-shape, rectangle, trapezoid, circular, semi-circular or semi-elliptical, etc. There may be provided one pressure relief structure, which is located in the central area of the first diaphragm and/or the second diaphragm. There may also be provided a plurality of the pressure relief structures, which are evenly distributed in the circumferential direction of the first diaphragm and/or the second diaphragm. In addition, when neither the first diaphragm nor the second diaphragm is provided with the air leakage structure, a hermetic space is formed between the first diaphragm and the second diaphragm which can prevent dust from accumulating between the first diaphragm and the second diaphragm and influencing the overall performance of the MEMS chip.

With the air leakage structure provided on the first diaphragm and/or the second diaphragm, it is possible to excellently buffer the high-pressure airflow received by the first diaphragm and/or the second diaphragm, and at the same time reduce the acoustic impedance of the first diaphragm and/or the second diaphragm, thereby improving the acoustic properties of the MEMS chip such as sensitivity and SNR. In addition, the MEMS chip provided with the air leakage structure can be applied to different sensors, such as a differential pressure sensor, which can widen the application range of the MEMS chip provided by the present disclosure.

In a specific embodiment of the present disclosure, as shown in FIGS. 3 and 4, the first back electrode 30 includes a first conductive layer 31 and a first non-conductive layer 32, and the second back electrode 50 includes a second conductive layer 51 and the second non-conductive layer 52, wherein the first non-conductive layer and the second non-conductive layer can be, for example, made of a non-conductive back electrode material known to those skilled in the art. The first conductive layer 31 is disposed inside the first non-conductive layer 32, and the second conductive layer 51 is disposed inside the second non-conductive layer 52. It can be understood that the conductive layer can also be disposed below and above the non-conductive layer. Preferably, according to the relationship between the conductive layer and the non-conductive layer and the material of the conductive layer, the conductive layer may optionally be bonded to the non-conductive layer by means of deposition, printing, spraying, photoresist, electroplating or electroless plating.

In a specific embodiment of the present disclosure, as shown in FIGS. 3 and 4, a first restraining portion 80 is provided between the first back electrode 30 and the first diaphragm 20 for restraining deformation of the first diaphragm 20 in a direction toward the first back electrode 30. With the first restraining portion 80, it is possible to restrict the extent to which first diaphragm 20 may deform in a direction toward first back electrode 30, so as to prevent adhesion or short circuit between the first diaphragm 20 and the first back electrode 30; and likewise, a second restraining portion 90 for restraining the deformation of the second diaphragm 40 in a direction toward the second back electrode 50 is provided between the second back electrode 50 and the second diaphragm 40. With the second restraining portion 90, it is possible to restrict the extent to which the second diaphragm 40 may deform in a direction toward the second back electrode 50, so as to prevent adhesion or short circuit between the second diaphragm 40 and the second back electrode 50.

shown in FIGS. 3 and 4, the first restraining portion 80 may also be provided at a side of the first non-conductive layer 32 of the first back electrode 30 adjacent to the first diaphragm 20 and can be integrally formed with the first non-conductive layer 32 of the first back electrode 30. When the first diaphragm 20 is greatly deformed in the direction toward the first back electrode 30, the first restraining portion 80 is in contact with the first diaphragm 20, therefore preventing the diaphragm from contacting the first conductive layer of the first back electrode, avoiding undesirable situations such as short-circuit, adhesion, and guaranteeing the normal operation of the diaphragm.

As shown in FIGS. 3 and 4, the second restraining portion 90 is formed on the side of the second non-conductive layer 52 of the second back electrode 50 adjacent to the second diaphragm 40, which may also avoid the second diaphragm from contacting the second conductive layer of the second back electrode, avoid an undesirable situation such as short-circuit, adhesion, and ensure the normal operation of the second diaphragm.

According to the invention, as shown in FIGS. 3 and 4, the first back electrode 30 is located at a side of the first diaphragm 20 away from the second plate capacitor structure, and the second diaphragm 40 is located at a side of the second back electrode 50 away from the first plate capacitor structure. Further, a spacing between the first diaphragm 20 and the second back electrode 50 is greater than a spacing between the first diaphragm 20 and the first back electrode 30, and greater than a spacing between the second diaphragm 40 and the second back electrode 50, respectively.

In a further specific embodiment, as shown in FIG. 4, the first diaphragm 20 and/or the second diaphragm 40 may include an air leakage structure. That is, only the first diaphragm is provided with the air leakage structure, or only the second diaphragm is provided with the air leakage structure, or both the first diaphragm 20 and the second diaphragm 40 are provided with the air leakage structure 70. With the air leakage structure provided on the first diaphragm and/or the second diaphragm, it is possible to excellently buffer the high-pressure airflow received by the first diaphragm and/or the second diaphragm, and at the same time reduce the acoustic impedance of the first diaphragm and/or the second diaphragm, thereby improving the acoustic properties of the MEMS chip such as sensitivity and SNR. In addition, the MEMS chip without the air leakage structure as shown in FIG. 3 can be applied to a rear sound entry type or front sound entry type MEMS microphone or a chip of a pressure sensor, while the MEMS chip with the air leakage structure as shown in FIG. 4 can be applied to the differential pressure sensor, thereby expanding the application range of the MEMS chip. In addition, when neither the first diaphragm 20 nor the second diaphragm 40 is provided with the air leakage structure 70, as shown in FIG. 3, the MEMS chip in this structure enables to form a hermetic space between the first diaphragm and the second diaphragm, and when the MEMS chip is applied to the rear sound entry type microphone, thereby preventing the performance of the MEMS chip from being damaged due to dust particles being blown into the MEMS chip, and improving the reliability of the MEMS chip.

In a preferred embodiment, as shown in FIGS. 3 and 4, a first restraining portion 80 is provided at a side of the first non-conductive layer 32 of the first back electrode 30 adjacent to the first diaphragm 20, and the first restraining portion 80 can be integrally formed with the first non-conductive layer 32 of the first back electrode 30. When the first diaphragm 20 is greatly deformed in the direction toward the first back electrode 30, the first restraining portion 80 is in contact with the first diaphragm 20, therefore preventing the first diaphragm from contacting the first conductive layer of the first back electrode, avoiding an undesirable situation such as short-circuit, adhesion, and guaranteeing the normal operation of the first diaphragm; in addition, as shown in FIGS. 3 and 4, a second restraining portion 90 is provided at a side of the second non-conductive layer 52 of the second back electrode 50 adjacent to the second diaphragm 40, and when the second diaphragm 40 is greatly deformed in the direction toward the second back electrode 50, the second restraining portion 90 is in contact with the second diaphragm 40, therefore preventing the second diaphragm from contacting the first conductive layer of the second back electrode, avoiding an undesirable situation such as short-circuit, adhesion, and guaranteeing the normal operation of the second diaphragm. Further, as shown in FIGS. 3 and 4, a third restraining portion 100 is provided at a side of the first diaphragm 20 adjacent to the second back electrode 50, the third restraining portion 100 may be integral with the first diaphragm 20, and when the first diaphragm 100 is greatly deformed in the direction toward the second back electrode 50, the third restraining portion 100 is in contact with the second non-conductive layer 52 of the second back electrode 50, therefore preventing the first diaphragm from contacting the second conductive layer of the second back electrode, avoiding an undesirable situation such as short-circuit, adhesion, and guaranteeing the normal operation of the first diaphragm.

## Claims

1. A MEMS chip, comprising:
a substrate (10) with a back cavity, and a plate capacitor bank provided on the substrate (10);
the plate capacitor bank at least comprises a first plate capacitor structure and a second plate capacitor structure located below the first plate capacitor structure and arranged in parallel with the first plate capacitor structure;
the first plate capacitor structure includes a first diaphragm (20) and a first back electrode (30);
the second plate capacitor structure includes a second diaphragm (40) and a second back electrode (50) ; **characterised in that**
the first back electrode is located at a side of the first diaphragm away from the second plate capacitor structure, and the second diaphragm is located at a side of the second back electrode away from the first plate capacitor structure.

2. The MEMS chip of claim 1, wherein the first diaphragm (20) and/or the second diaphragm (40) comprises an air leakage structure (70).

3. The MEMS chip of claim 1, wherein a hermetic space is formed between the first diaphragm (20) and the second diaphragm (40).

4. The MEMS chip of claim 1, wherein a first restraining portion for restraining deformation of the first diaphragm (20) toward the first back electrode (30) is provided between the first back electrode (30) and the first diaphragm (20); and
a second restraining portion for restraining deformation of the second diaphragm (40) toward the second back electrode (50) is provided between the second back electrode (50) and the second diaphragm (40).

5. The MEMS chip of claim 1, wherein a spacing between the first diaphragm (20) and the second back electrode (50) is greater than a spacing between the first diaphragm (20) and the first back electrode (30), and greater than a spacing between the second diaphragm (40) and the second back electrode (50), respectively.

## Patentansprüche

1. MEMS-Chip, umfassend:
ein Substrat (10) mit einem rückseitigen Rückhohlraum und eine auf dem Substrat (10) angeordnete Flachplattenkondensatoranordnung, wobei
die Flachplattenkondensatoranordnung mindestens eine erste Flachplattenkondensatorstruktur und eine zweite Flachplattenkondensatorstruktur umfasst, die sich unterhalb der ersten Flachplattenkondensatorstruktur befindet und parallel zu der ersten Flachplattenkondensatorstruktur angeordnet ist, wobei
die erste Flachplattenkondensatorstruktur eine erste Membran (20) und eine erste Rückelektrode (30) umfasst, und
die zweite Flachplattenkondensatorstruktur eine zweite Membran (40) und eine zweite Rückelektrode (50) umfasst,
**dadurch gekennzeichnet, dass** sich die erste Rückelektrode auf einer von der zweiten Flachplattenkondensatorstruktur abgewandten Seite der ersten Membran befindet und sich die zweite Membran auf einer von der ersten Flachplattenkondensatorstruktur abgewandten Seite der zweiten Rückelektrode befindet.

2. MEMS-Chip nach Anspruch 1, **dadurch gekennzeichnet, dass** die erste Membran (20) und/oder die zweite Membran (40) eine Luftablassstruktur (70) umfasst.

3. MEMS-Chip nach Anspruch 1, **dadurch gekennzeichnet, dass** zwischen der ersten Membran (20) und der zweiten Membran (40) ein geschlossener Raum gebildet ist.

4. MEMS-Chip nach Anspruch 1, **dadurch gekennzeichnet, dass** zwischen der ersten Rückelektrode (30) und der ersten Membran (20) ein erster Begrenzungsabschnitt zum Begrenzen der Verformung der ersten Membran (20) in Richtung der ersten Rückelektrode (30) angeordnet ist, und
zwischen der zweiten Rückelektrode (50) und der zweite Membran (40) ein zweiter Begrenzungsabschnitt zum Begrenzen der Verformung der zweiten Membran (40) in Richtung der zweiten Rückelektrode (50) angeordnet ist;

5. MEMS-Chip nach Anspruch 1, **dadurch gekennzeichnet, dass** der Abstand zwischen der ersten Membran (20) und der zweiten Rückelektrode (50) größer ist als der Abstand zwischen der ersten Membran (20) und der ersten Rückelektrode (30) und der Abstand zwischen der zweiten Membran (40) und der zweiten Rückelektrode (50).

## Revendications

1. Puce MEMS, comprenant :
un substrat (10) présentant une cavité arrière, et une batterie de condensateurs à plaques disposée sur le substrat (10);
la batterie de condensateurs à plaques comprend au moins une première structure de condensateur à plaques et une seconde structure de condensateur à plaques située en dessous de la première structure de condensateur à plaques et disposée en parallèle avec la première structure de condensateur à plaques;
la première structure de condensateur à plaques comprend un premier diaphragme (20) et une première électrode arrière (30);
la seconde structure de condensateur à plaques comprend un second diaphragme(40) et une seconde électrode arrière (50),
**caractérisé en ce que** la première électrode arrière est située du côté du premier diaphragme éloignée de la seconde structure de condensateur à plaques, et le second diaphragme est situé du côté de la seconde électrode arrière éloignée de la première structure de condensateur à plaques.

2. Puce MEMS selon la revendication 1, **caractérisé en ce que** le premier diaphragme (20) et/ou le second diaphragme (40) comprend une structure de fuite d'air (70).

3. Puce MEMS selon la revendication 1, dans laquelle un espace hermétique est formé entre le premier diaphragme (20) et le second diaphragme (40).

4. Puce MEMS selon la revendication 1, **caractérisé en ce que** une première portion de limitation destinée à limiter la déformation du premier diaphragme (20) vers la première électrode arrière (40) est disposée entre la première électrode arrière (30) et le premier diaphragme (20);
une seconde portion de limitation destinée à limiter la déformation du second diaphragme (40) vers la seconde électrode arrière (50) est disposée entre la seconde électrode arrière (50) et le second diaphragme (40).

5. Puce MEMS selon la revendication 1, **caractérisé en ce que** un espacement entre le premier diaphragme (20) et la seconde électrode arrière (50) est supérieur à un espacement entre le premier diaphragme (20) et la première électrode arrière (30), et supérieur à un espacement entre le second diaphragme (40) et la seconde électrode arrière (50), respectivement.
